# EUROPEAN PATENT APPLICATION

(11) **EP 3 327 802 A1**
(43) Date of publication of application: **30.05.2018**
(21) Application number: 16382560.7
(22) Date of filing: 24.11.2016
(51) Int. Cl.: H01L 33/48, H01L 33/62

(54) **METHOD FOR CREATING A CONDUCTIVE TRACK AND SEALING SYSTEM**

(71) Applicant: VALEO ILUMINACION, 23600 Martos (ES)
(72) Inventor: TEBA, Daniel, 23600 MARTOS (ES); GUZMAN, Alfonso-Manuel, 23560 HUELMA (ES); MARTINEZ, Francisco, 18500 GUADIX (Granada) (ES)

(57) **Abstract**

Method for manufacturing an electronic assembly (10), the method comprising the steps of providing a plastics substrate (2), placing a sealing joint (3) on the plastics substrate (2) so as to define a protected area (21) on the plastics substrate (2), forcing the sealing joint (3) against the plastics substrate (2) by means of a shutter (4) and a pushing device (5), and depositing metal dust contained in a plasma flow (6) on the protected area (21) to create a conductive track (1). The shutter (4) and the sealing joint (3) prevent the metal dust (7) from being deposited plastics substrate outside the protected area (21). After these steps, the shutter (4) and the pushing device (5) are removed, thus obtaining an electronic assembly (10). The invention also includes an electronic assembly (10) and a lighting device (11).

## Description

### TECHNICAL FIELD

This invention belongs to the field of methods which are intended to manufacture electronic assemblies and automotive lighting devices comprising such assemblies.

### STATE OF THE ART

Plasma deposition is sometimes used to create a conductive track on a plastics substrate. This process comprises the step of including in the plasma flow some metal dust particles, usually copper, that are melted by the plasma flow and then deposited on the plastic part, thus creating a conductive track on said plastic part.

One example of this process may be found in document US 2015/174686 A1.

But when a conductive track is created by this method, it is very common that metal particles which are not deposited on the plastic part outside the conductive track remain in the ambient. These particles, in the form of dust, may contaminate the rest of the plastics substrate and may be dangerous for operators in the event they breathe it.

Patent EP 2247766 B1 shows a way of solving this problem by the use of masks when creating these tracks. However, these masks need to be specifically designed for each track and plastic part geometry, which make it expensive and non-practical for its use in a field with different and varied shapes and geometries. Further, these masks are employed to limit the conductive tracks so, after being used, they are contaminated with metal particles, thus losing tightness, thus being less useful for their purpose.

It is then desirable to provide an alternative to these methods which provide for a more versatile way of avoiding contamination of metal particles in the edges of the conductive tracks.

### DESCRIPTION OF THE INVENTION

The invention provides a solution for this problem by means of a method for manufacturing an electronic assembly according to claim 1, an electronic assembly according to claim 5 and a lighting device according to claim 6. Preferred embodiments of the invention are defined in dependent claims.

In a first inventive aspect, the invention provides a method for manufacturing an electronic assembly, the method comprising the steps of
providing a plastics substrate;
placing a sealing joint on the plastics substrate so as to define a protected area on the plastics substrate,
forcing the sealing joint against the plastics substrate by means of a shutter and a pushing device, in such a way that the plastics substrate is placed between the shutter and the pushing device,
depositing metal dust contained in a plasma flow on the protected area to create a conductive track, the shutter and the sealing joint preventing the metal dust from being deposited outside the protected area;
removing the sealing joint, the shutter and the pushing device, thus obtaining the electronic assembly.

The aim of the sealing joint and the shutter is avoiding that the metal dust which is not finally deposited on the plastics substrate, contaminates the rest of the plastics substrate or is inhaled by the operators. In some embodiments, the sealing joint is therefore located far enough from the protected area thus preventing the melted metal dust from being deposited on the sealing joint.

This method advantageously achieves a tight separation between the spare metal dust and the rest of the plastics substrate, so that the spare metal dust does not contaminate the plastics substrate, which usually needs to fulfil high cleanness standards.

As a consequence, the sealing joint may be used during more cycles than the mask.

In some particular embodiments, the shutter, the sealing joint and the protected area define a closed volume.

This method advantageously achieves that all the spare metal dust is confined by the shutter, so that it may be collected and recycled in its entirety.

In a particular embodiment, the sealing joint is placed at the same time as the shutter.

This method advantageously provides a faster and more precise way of using the shutter.

In some particular embodiments, the plastics substrate comprises a predetermined track, and the metal dust is deposited in the predetermined track of the plastics substrate.

The size of the conductive track is limited by the predetermined track which is contained in the plastics substrate. The predetermined track constitutes poses a physical barrier for the melted metal dust which is deposited on the plastics substrate, so it does not reach the sealing joint.

This makes it easier to deposit the conductive track, since the predetermined track offers a help for the operator, for a better delimitation of the location of the conductive track. The predetermined track has a shape such that spare particles are gathered within the predetermined track.

In another inventive aspect, the invention provides an electronic assembly manufactured by a method according to the previous inventive aspect.

This electronic assembly is free from metal dust, since the shutter and the pushing device have prevented metal dust from contaminating the electronic assembly and the air surrounding the electronic assembly. The handling of this product is therefore easier and safer.

In some particular embodiments, the contact surface is the only opening of the shutter.

This system provides a good way of recovering the spare metal dust, so that it may be recycled.

In another inventive aspect, the invention provides a lighting device comprising
an electronic assembly according to the previous inventive aspect;
a light source arranged in electric connection with the electronic assembly,
an optical element suitable for receiving light emitted by the light source and for shaping the light into a light pattern projected outside the lighting device; and
a housing accommodating the electronic assembly, the light source and the optical element.

An optical element is an element that has some optical properties to receive a light beam and emit it in a certain direction and/or shape, as a person skilled in automotive lighting would construe without any additional burden. Reflectors, collimators, light guides, projection lenses, etc., or the combination thereof are some examples of these optical elements.

Lighting devices for automotive vehicles can benefit from the use of electronic assemblies comprising conductive tracks directly deposited on a plastics substrate. In the first place, a wide range of the lighting device's parts can be used either as plastics substrate or as base for the plastics substrate (in which case the plastics substrate may for instance coat the base), taking into account that even three-dimensional plastics substrates are suitable for direct deposition of conductive tracks. Therefore, a dedicated printed board circuit is not required, which leads to reducing the cost and the weight of the lighting device. As was stated above, cost savings are even more significant due to the fact that direct deposition does not normally want removing conductive material to shape the conductive tracks.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figures 1 a and 1 b show the steps of a particular embodiment of a method for manufacturing an electronic assembly according to the invention.
Figure 2 shows an electronic assembly according to the invention.
Figure 3 shows a lighting device according to the invention installed in an automotive vehicle.

### DETAILED DESCRIPTION OF THE INVENTION

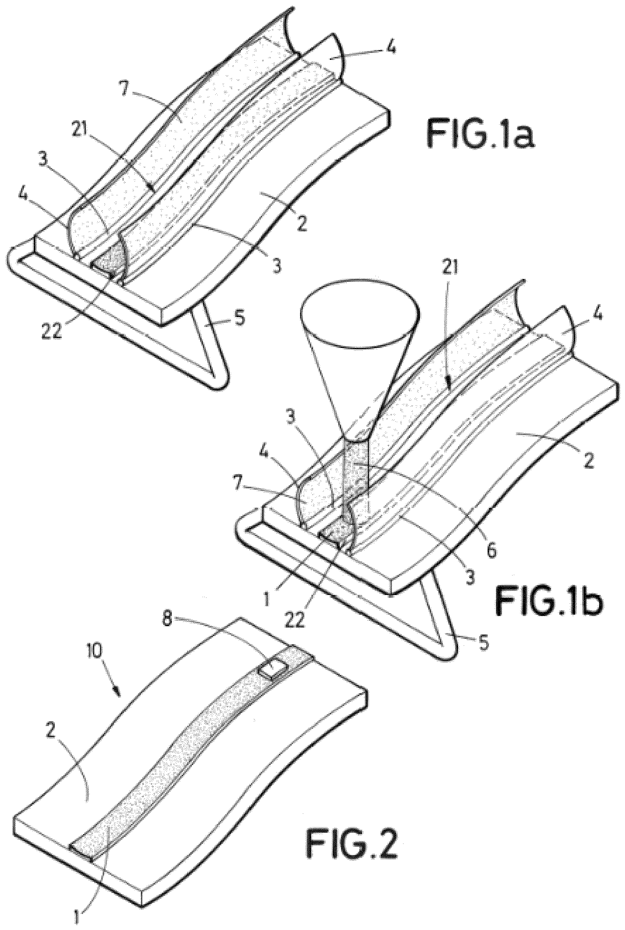

Figures 1a and 1 b show the steps of a particular embodiment of a method for manufacturing an electronic assembly 10 according to the invention. This method comprises the steps of
providing a plastics substrate 2;
placing a sealing joint 3 on the plastics substrate 2, so as to define a protected area 21 on the plastics substrate 2
forcing the sealing joint 3 against the plastics substrate 2 by means of a shutter 4 and a pushing device 5, in such a way that the plastics substrate 2 is placed between the shutter 4 and the pushing device 5; and
depositing melted metal dust 7 contained in a plasma flow 6 on the predetermined track 22 to create the conductive track 1, the shutter 4 and the sealing joint 3 preventing the metal dust 7 from being deposited outside the protected area 21.

Finally, the sealing joint 3, the shutter 4 and the pushing device 5 are removed, thus obtaining the electronic assembly 10.

The plastics substrate 2 comprises a predetermined track 22 intended to limit the size of the conductive track 1 to be created, and provide a concrete location for this conductive track 1 to be deposited.

Figure 1 a shows the two first steps of this method. A plastics substrate 2 is provided with a predetermined track 22, intended to receive the metal dust particles. A protected area 21 is defined by the placement of the sealing joint 3. The sealing joint 3 is laid on this plastics substrate 2, and it is forced to be in contact with this plastics substrate 2 by means of the shutter 4 and the pushing device 5. The shutter 4 and the pushing device 5 are placed to force the sealing joint 3 against the plastics substrate 2, in such a way that the plastics substrate 2 is placed between the shutter 4 and the pushing device 5. Any pushing device 5 is suitable for this step as soon as it is suitable for pressing the plastics substrate 2 against the sealing joint 3 and the shutter 4.

As may be seen in this figures, the shutter 4, the sealing joint 3 and the protected area 21 define an open volume, since the shutter 4 is open, but in other embodiments, the shutter 4 is closed in a doomed shape, so that the shutter 4, the sealing joint 3 and the protected area 21 define a closed volume.

Figure 1 b shows the last step of this method, where melted metal dust contained in a plasma flow 6 is deposited on the predetermined track 22 to create the conductive track 1.

Throughout this process, some of the metal dust 7 which is contained in the plasma flow 6 is not deposited on the plastics substrate 2, but stays in the shape of metal dust. The sealing joint 3, the shutter 4 and the pushing device 5 prevents this metal dust 7 from contaminating the rest of the plastics substrate 2 or the respiratory tract of the operators in charge of this process.

Figure 2 shows an electronic assembly 10 according to the invention. This electronic assembly 10 comprises
the plastics substrate 2;
the conductive track 1 deposited on the plastics substrate 2 by a method according to the invention; and
a semiconductor light source 8.

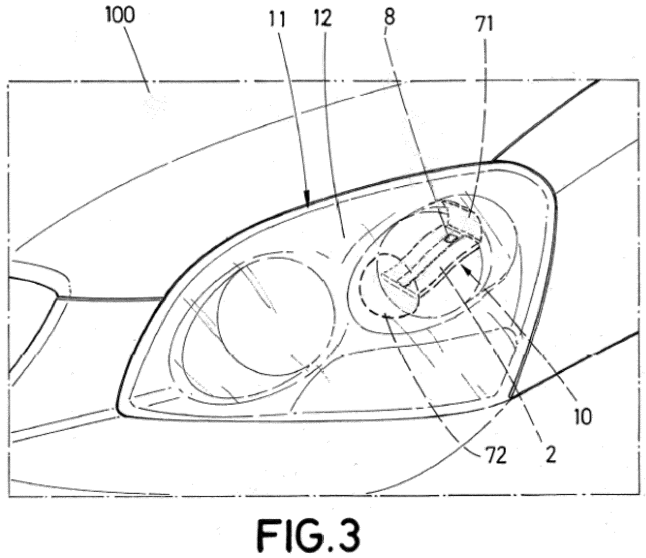

Figure 3 shows a lighting device 11 for an automotive vehicle 100 comprising
an electronic assembly 10 as shown in figure 2;
a reflector 71 and a projection lens 72, suitable for receiving light from the light source 8 and projecting it in the shape of a light pattern in a forward direction; and
a housing accommodating the electronic assembly 10, the reflector 71 and the projection lens 72.

The forward direction should be understood as the advance direction of an automotive vehicle where the lighting device is intended to be installed.

In the particular embodiment shown in this figure, the optical elements include a reflector 71 and a projection lens 72. The reflector 71 is placed in the electronic assembly 10, arranged to reflect the light emitted by the light source 8. The projection lens is in turn located in a forward position with respect to the lighting device 10, and receives the light from the light source 8 which has been reflected by the reflector 71. The projection lens 72 orientates this received light according to the vehicle advancing direction.

These optical elements 71, 72 makes the lighting device 11 suitable for being installed in an automotive vehicle 100 and able to perform lighting functions, such as high-beam and low-beam.

This lighting device 11 may be incorporated in an automotive vehicle 100.

## Claims

1. Method for manufacturing an electronic assembly (10), the method comprising the steps of
providing a plastics substrate (2);
placing a sealing joint (3) on the plastics substrate (2) so as to define a protected area (21) on the plastics substrate (2),
forcing the sealing joint (3) against the plastics substrate (2) by means of a shutter (4) and a pushing device (5), in such a way that the plastics substrate (2) is placed between the shutter (4) and the pushing device (5),
depositing metal dust contained in a plasma flow (6) on the protected area (21) to create a conductive track (1), the shutter (4) and the sealing joint (3) preventing the metal dust (7) from being deposited outside the protected area (21);
removing the sealing joint (3), the shutter (4) and the pushing device (5), thus obtaining the electronic assembly (10).

2. Method according to claim 1, wherein the shutter (4), the sealing joint (3) and the protected area (21) define a closed volume.

3. Method according to any of preceding claims, wherein the sealing joint (3) is placed at the same time as the shutter (4).

4. Method according to any of preceding claims, wherein the plastics substrate (2) comprises a predetermined track (22), and the metal dust (7) is deposited in the predetermined track (22) of the plastics substrate.

5. Electronic assembly (10) manufactured by a method according to any of the preceding claims.

6. Lighting device (11) comprising
an electronic assembly (10) according to claim 5;
a light source (8) arranged in electric connection with the electronic assembly (10),
an optical element (71, 72) suitable for receiving light emitted by the light source (8) and for shaping the light into a light pattern projected outside the lighting device (11); and
a housing (12) accommodating the electronic assembly (10), the light source (8) and the optical element (71, 72).
